(19) 

Europäisches Patentamt
European Patent Office
Office européen des brevets

(11) **EP 2 463 401 B1**

(12) **EUROPÄISCHE PATENTSCHRIFT**

(45) Veröffentlichungstag und Bekanntmachung des Hinweises auf die Patenterteilung:
**24.07.2013  Patentblatt 2013/30**

(51) Int Cl.:
*C23C 14/34* (2006.01)      *H01J 37/34* (2006.01)
*G11B 5/851* (2006.01)

(21) Anmeldenummer: **12001531.8**

(22) Anmeldetag: **24.12.2007**

(54) **Vorrichtung zur Herstellung einer gerichteten Schicht mittels Kathodenzerstäubung und Verwendung derselben**

Apparatus for manufacturing a directional layer by means of cathodic sputtering and its use

Appareil de fabrication d'une couche orientée par pulvérisation cathodique et son utilisation

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **02.01.2007   US 883086 P**

(43) Veröffentlichungstag der Anmeldung:
**13.06.2012   Patentblatt 2012/24**

(62) Dokumentnummer(n) der früheren Anmeldung(en) nach Art. 76 EPÜ:
**07845644.9 / 2 106 457**

(73) Patentinhaber: **OC Oerlikon Balzers AG**
**9496 Balzers (LI)**

(72) Erfinder:
• **Rohrmann, Hartmut**
  **69198 Schriesheim (DE)**

• **Friedli, Hanspeter**
  **7012 Felsberg (CH)**
• **Weichart, Jürgen**
  **9496 Balzers (LI)**
• **Kadlec, Stanislav**
  **150 00 Praha 5 (CZ)**
• **Dubs, Martin**
  **7304 Maienfeld (CH)**

(74) Vertreter: **Wagner, Wolfgang Heribert et al**
**Wagner Patent AG**
**Apollostrasse 2**
**Postfach 1021**
**8032 Zürich (CH)**

(56) Entgegenhaltungen:
**US-A1- 2003 019 745**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

**Technisches Gebiet**

Die Erfindung betrifft eine Vorrichtung zur Herstellung einer gerichteten Schicht auf einer ebenen Substratfläche mit einer jeweils in derselben liegenden ausgezeichneten Richtung mittels Kathodenzerstäubung. Derartige Schichten sind oft magnetische Schichten oder Trägerschichten für magnetische Schichten, die eine bevorzugte Magnetisierungsrichtung aufweisen. Sie werden vor allem in Speichereinrichtungen für Datenverarbeitungsanlagen eingesetzt, z.B. in Schreib/Leseköpfen für Festplatten und MRAMs. Die Erfindung betrifft ausserdem eine entsprechende Verwendung der Vorrichtung.

**Stand der Technik**

Gemäss US 6 790 482 B2 bekannt. Dort wird auf einer ebenen Substratfläche eine gerichtete magnetische Schicht hergestellt, welche in einer bestimmten, im wesentlichen konstanten ausgezeichneten Richtung leichter magnetisierbar ist (sog. easy axis) als in anderen Richtungen, insbesondere normal zur ausgezeichneten Richtung. Zur Ausrichtung der Magnetschicht sind unterhalb des Substrats Elektromagnete angeordnet, die ein Magnetfeld erzeugen, an dessen Feldlinien sich die auf die Substratfläche auftreffenden Partikel magnetisch ausrichten, derart, dass die ausgezeichnete Richtung zu den Feldlinien parallel ist.

Diese Lösung ist nicht in jedem Anwendungsfall befriedigend, da die tatsächliche Ausrichtung zonenweise ziemlich weit von der erwünschten konstanten ausgezeichneten Richtung abweicht. Ausserdem sind Ausdehnung und Form des Substrats beschränkt, wenn annehmbare Ergebnisse erzielt werden sollen.

Eine ähnliche Vorrichtung, bei der Permanentmagnete zum Einsatz kommen, ist in US 2003/0 146 084 A1 beschrieben. Hier wird ein zwischen Target und Substrat angeordneter geerdeter Kollimator zur Beschränkung des Einfallswinkels von Partikeln auf die Substratfläche durch Abfangen von Partikeln mit stärker von der Flächennormalen abweichenden Winkeln eingesetzt und dient ausserdem dazu, das Plasma vom Substrat fernzuhalten.

Eine weitere, der eben beschriebenen ähnliche Vorrichtung ist aus WO 96/08 817 A1 bekannt. Auch hier wird ein Kollimator eingesetzt, dessen Längenverhältnis dazu benutzt wird, Parameter der magnetischen Schicht so zu steuern, dass die Ausrichtung der Kristalle entweder in der Ebene der Substratfläche erfolgt oder aber normal zu dieser. Im ersteren Fall wird dabei allerdings keine ausgezeichnete Richtung innerhalb der besagten Ebene angestrebt.

Ein weiteres derartiges Verfahren, bei dem zur Vermeidung von Unregelmässigkeiten und magnetischer Anisotropie flacher Einfall von Partikeln auf die Substratfläche durch einen Kollimator unterbunden wird, ist aus US 6 482 301 B1 bekannt.

Weiter ist aus US 5 584 973 A eine ähnliche Vorrichtung bekannt, bei der zwecks Sicherstellung einer ausreichenden Beschichtung auch in tiefen, engen Kontaktlöchern der Oberfläche der Einfallswinkel durch einen zwischen einem Target und einem Substrat angeordneten Kollimator eingeschränkt wird, der zwei knapp übereinander angeordnete Scharen von parallelen, normal zur Substratoberfläche gerichteten Platten umfasst, die einander rechtwinklig kreuzen. Die Platten können z.B. um mittige Längsachsen gedreht werden. Durch Drehen der Platten um 180° zwischen zwei Sputter-Vorgängen mit verschiedenen Materialien sollen Verunreinigungen verringert werden.

Ebenfalls zum Zweck, eine gleichmässige Beschichtung, auch in Vertiefungen wie Kontaktlöchern, auf einem Halbleiter sicherzustellen, ist gemäss US 5 650 052 A ein Kollimator vorgesehen, welcher Zellen vorzugsweise sechseckigen Querschnitts bildet. Die Zellen können unterschiedliche Längen und Durchmesser aufweisen, z.B. kann die Oberseite des Kollimators gestuft sein, derart, dass die Länge der Zellen gegen äussere Ränder hin abnimmt.

Eine weitere Vorrichtung ist US 2003/062 260 A1 zu entnehmen. Sie dient zur Aufbringung einer gerichteten Trägerschicht zur Herstellung einer magnetischen Schicht für ein Speichermedium auf einer Oberfläche eines Substrats, wobei drei Targets eingesetzt werden und ein zwischen diesen und dem Substrat angeordneter Kollimator mit radialen Platten, der zur Vermeidung von Schatten um eine zentrale Achse rotiert. Wenn die Platten parallel zur Achse sind, so wird je nach Art der Trägerschicht eine magnetische Schicht mit einer ausgezeichneten Richtung hergestellt, die z.B. radial gerichtet ist. Die Platten können auch gleichsinnig gegenüber der Achse geneigt sein. Die Vorrichtung eignet sich nicht für die Herstellung einer gerichteten Schicht mit einer konstanten ausgezeichneten Richtung.

Schliesslich ist aus US 2003/019 745 A1 eine gattungsgemässe Vorrichtung bekannt, bei der ein Kollimator mit parallelen, gegenüber der Substratfläche geneigten Platten. Sie dient zur Aufbringung einer Schicht mit einer bestimmten Säulenstruktur, d.h. Säulen, welche jeweils parallel zur Einfallsrichtung der Partikel sind. Eine solche Vorrichtung ist zur Herstellung einer Schicht mit einer in der Substratfläche liegenden ausgezeichneten Richtung kaum geeignet. Wegen der Neigung der Platten bewirkt der Kollimator eine starke Abschattung und verschmutzt entsprechend schnell. Die Abschattung ist auch über die Substratfläche sehr unterschiedlich, was entsprechende Unterschiede der Schichtdicke nach sich zieht.

## Darstellung der Erfindung

Der Erfindung liegt die Aufgabe zu Grunde, eine gattungsgemässe Vorrichtung anzugeben, mit der eine Schicht mit konstanter ausgezeichneter Richtung angelegt werden kann, bei der die letztere auf der ganzen Substratfläche mit hoher Genauigkeit eingehalten ist und Unterschiede in der Dicke der Schicht verhältnismässig geringfügig sind.
Diese Aufgabe wird durch die Merkmale im Kennzeichen des Anspruchs 1 gelöst. Durch die erfindungsgemässe Anordnung und Ausbildung des Kollimators wird eine konstante ausgezeichneten Richtung über die gesamte Substratfläche festgehalten. Unterschiede in der Dicke der Schicht, wie sie sich sonst aus den Asymmetrien der Anordnung ergeben würden, werden weitgehend vermieden.
Ausserdem wird eine bevorzugte Verwendung einer erfindungsgemässen Vorrichtung angegeben.

## Kurze Beschreibung der Zeichnungen

Im folgenden wird die Erfindung anhand von Figuren, welche lediglich Ausführungsbeispiele darstellen, näher erläutert. Es zeigen

Fig. 1     eine schematische Draufsicht auf eine erfindungsgemässe Vorrichtung gemäss einer ersten Ausführungsform,

Fig. 2     einen Schnitt längs II-II in Fig. 1,

Fig. 3     eine Frontansicht eines Targets der Vorrichtung nach Fig. 1, 2,

Fig. 4     einen schematischen Aufriss einer erfindungsgemässen Vorrichtung gemäss einer zweiten Ausführungsform,

Fig. 5     eine schematische Draufsicht auf eine Abschirmvorrichtung der Vorrichtung gemäss Fig. 4,

Fig. 6     ein Element einer Abschirmvorrichtung gemäss einer besonderen Ausführungsform,

Fig. 7a    einen Schnitt durch eine Einfallskeule an einem Zielpunkt einer Substratfläche parallel zu einer ausgezeichneten Richtung,

Fig. 7b    einen Schnitt durch die Einfallskeule normal zur ausgezeichneten Richtung und

Fig. 8     einen kumulierten Partikeleinfall am Zielpunkt als Funktion der Richtung in der Tangentialebene.

## Wege zur Ausführung der Erfindung

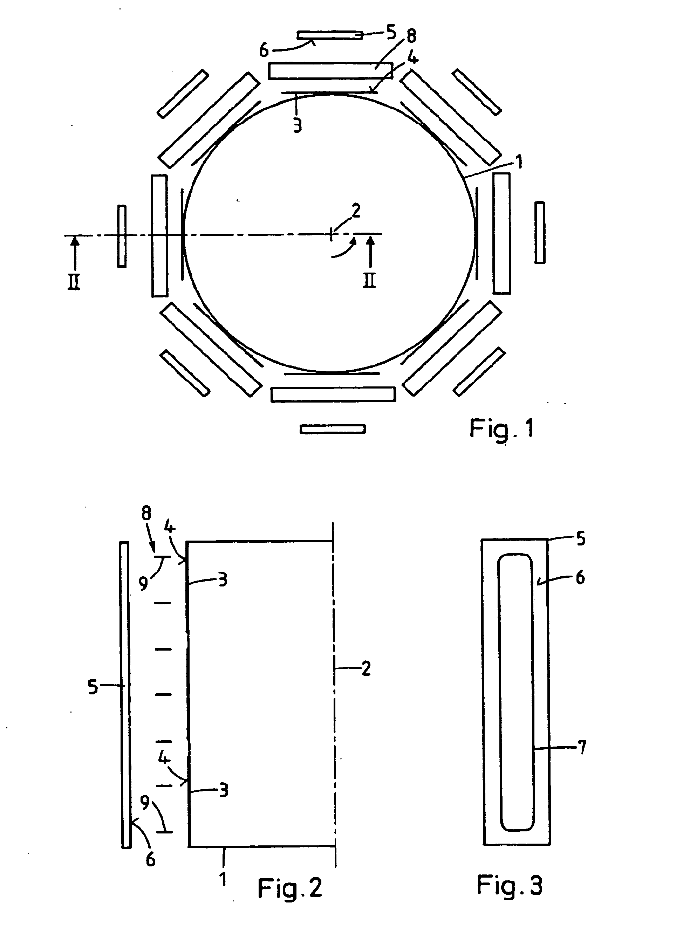

Die Vorrichtung gemäss Fig. 1-3 ist in einer Vakuumkammer (nicht dargestellt) angeordnet. Sie weist einen zylindrischen Korb 1 auf, der um eine Achse 2 drehbar ist und an seiner Aussenseite Halterungen trägt, an denen Substrate 3 mit nach aussen weisenden ebenen Substratflächen 4 befesteigt sind. Die Substrate 3 können etwa Scheiben von ca. 200mm Durchmesser sein, welche nach ihrer Fertigstellung z.B. zur Herstellung von Komponenten für Schreib/ Leseköpfe zersägt werden. Der Korb 1 ist mit einigem Abstand von Targets 5 umgeben, welche als längliche senkrechte Platten ausgebildet sind, die der Achse 2 eine Targetfläche 6 zuwenden. Die Targets 5 sind in bekannter Weise als Magnetron-Targets ausgebildet, d.h. hinter der Targetfläche 6 sind Magnete angeordnet, welche ein im Bereich der Targetfläche 6 um eine geschlossene Kurve 7 (Fig. 3) konzentriertes Magnetfeld erzeugen, sodass das Target 5 vor allem in diesem Bereich abgetragen wird und sich entsprechende Erosionsgräben in der Targetfläche 6 ausbilden.
Zwischen jedem der Targets 5 und dem Korb 1 ist, etwas näher an der Substratfläche 4 als an der Targetfläche 6, als Abschirmvorrichtung ein Kollimator 8 angeordnet, der als Kammkollimator mit mehreren mit Abstand kongruent übereinander angebrachten parallelen rechteckigen Platten 9, welche z.B. aus Aluminium bestehen, ausgebildet ist. Der Abstand zwischen der Targetfläche 6 und der Substratfläche 4 kann z.B. 75mm betragen, der Abstand zwischen dem Kollimator 8 und Substratfläche 4 30mm, die Länge der Platten 9 10mm und ihr Abstand 50mm.
Zur Herstellung jeweils einer gerichteten Schicht auf jeder der Substratflächen 4 werden die Substrate 3 während einer Beschichtungszeit mittels Kathodenzerstäubung in an sich bekannter Weise mit Targetmaterial bedampft, während der Korb 1 langsam und gleichmässig, z.B. mit 0,1U/s gedreht wird. Durch die Drehung einerseits und die Wirkung der Kollimatoren 8 andererseits wird dabei jeweils eine Schicht hergestellt, welche eine über die Substratfläche 4 konstante ausgezeichnete Richtung hat, die jeweils der Richtung der Schnittlinien der zur Achse 2 normalen Ebenen mit der Substratfläche 4 entspricht, im vorliegenden Fall also horizontal ist. Dies wird weiter unten noch näher erläutert.

Das schliesslich angestrebte Ergebnis kann etwa eine weichmagnetische Schicht auf der Substratfläche sein, welche eine bevorzugte Magnetisierungsrichtung aufweist, d.h. eine Richtung, in welcher die Schicht schon durch ein verhältnismässig kleines Magnetfeld magnetisierbar ist (sog. easy axis), während in der dazu normalen Richtung ein wesentlich höheres Magnetfeld erforderlich ist (sog. hard axis). Dabei kann so vorgegangen werden, dass Targets 5 verwendet werden, die im wesentlichen aus dem weichmagnetischen Material wie Nickel-Eisen, z.B. NiFe21, oder Kobalt-Eisen bestehen und somit auf eine die Substratfläche 4 bildende Grundschicht direkt eine Schicht aus dem weichmagnetischen Material aufgesputtert wird, welche eine bevorzugte Magnetisierungsrichtung aufweist. In den meisten Fällen entspricht diese der ausgezeichneten Richtung, doch kann sie bei anderer Materialwahl auch anders ausgerichtet sein, gewöhnlich normal zur ausgezeichneten Richtung. Mit einer Anlage, die wie oben beschrieben aufgebaut war, wurde eine gerichtete Schicht hergestellt, bei der die ausgezeichnete Richtung um höchsten 0.5° vom Sollwert abwich.

Eine andere Möglichkeit, eine magnetische Schicht mit einer bevorzugten Magnetisierungsrichtung auf der Substratfläche 4 anzulegen, besteht darin, zuerst eine gerichete Trägerschicht, z.B. aus Chrom, Vanadium oder Wolfram aufzudampfen und anschliessend auf dieser Trägerschicht, eine Schicht aus magnetischem Material anzulegen, deren bevorzugte Magnetisierungsrichtung dann durch die ausgezeichnete Richtung der Trägerschicht bestimmt wird, gewöhnlich, indem sie sich je nach den eingesetzten Materialien parallel oder auch normal zu derselben einstellt. Dabei sind beim Anlegen der magnetischen Schicht, die gewöhnlich ebenfalls durch Kathodenzerstäubung erfolgt, keine besonderen Massnahmen zur Herstellung einer ausgezeichneten Richtung erforderlich, obwohl sie zusätzlich getroffen werden können. In jedem Fall kann etwa die Ausbildung der bevorzugten Magnetisierungsrichtung in an sich bekannter Weise dadurch unterstützt werden, dass beim Aufdampfen der magnetischen Schicht ein Magnetfeld angelegt wird, das im Bereich der Substratfläche 4 wirksam ist, indem z.B. seine Projektion auf die Substratfläche in jedem Zielpunkt derselben mit der bevorzugten Magnetisierungsrichtung übereinstimmt.

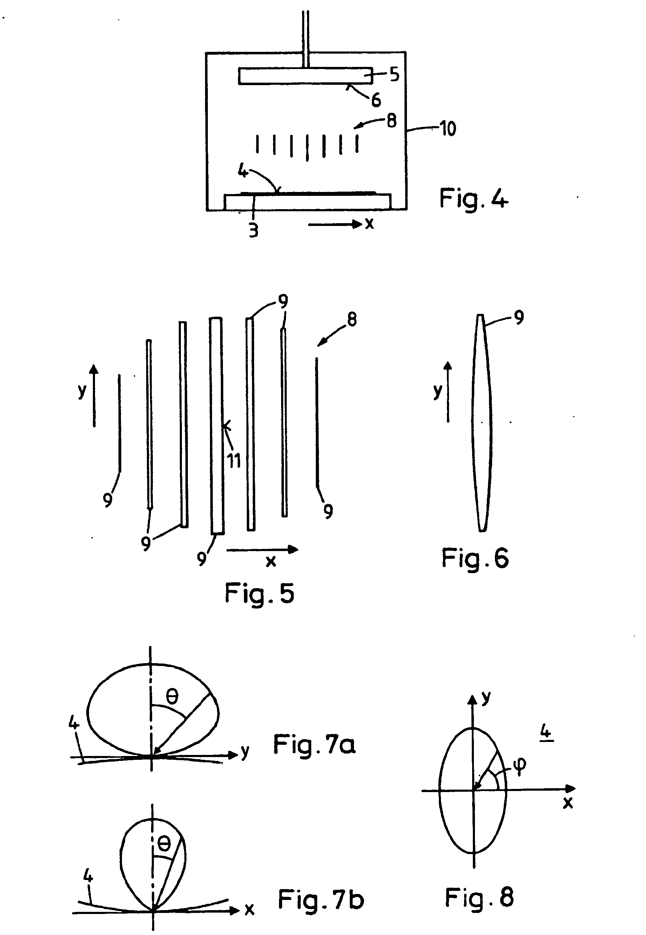

Eine weitere erfindungsgemässe Vorrichtung ist in Fig. 4 dargestellt. Hier ist das Substrat 3 derart stationär am Boden einer Vakuumkammer 10 angeordnet, dass die ebene Substratfläche 4 nach oben weist. An der Decke der Vakuumkammer 10 ist ein Target 5 mit einer nach unten gegen das Substrat 3 weisenden Targetfläche 6 angebracht. Das Substrat 3 und das Target 5 sind scheibenförmig. Die wiederum hinter der Targetfläche 6 angeordneten Magnete sind drehbar. Zwischen dem Target 5 und dem Substrat 3 ist wieder eine Abschirmvorrichtung angeordnet, welche wiederum als Kollimator 8 ausgebildet ist.

Der Kollimator 8 ist wieder als Kammkollimator ausgebildet, der sich (Fig. 5) aus parallelen, ebenen Platten 9 zusammensetzt, die wieder aus Aluminium bestehen können und normal zur Substratfläche 4 gerichtet sind, also im vorliegenden Fall vertikal. Parallel zur Substratfläche 4 sind sie nach einer y-Richtung ausgerichtet. Die Abstände, mit der benachbarte Platten 9 in einer zur y-Richtung normalen, ebenfalls zur Substratebene parallelen x-Richtung aufeinanderfolgen, nehmen vorzugsweise von der Mitte nach den äusseren Rändern hin langsam zu. Die Platten 9 können unterschiedliche Längen oder mittlere Längen und/oder Dicken oder mittlere Dicken aufweisen, vorzugsweise so, dass die Länge und/oder die Dicke von einer Mitte nach beiden Aussenrändern hin in x-Richtung im allgemeinen abnimmt. Bei über die Fläche, insbesondere in y-Richtung, also parallel zur Substratfläche 4 sich ändernder Dicke der einzelnen Platte 9 nimmt diese ebenfalls vorzugsweise von der Mitte nach beiden Aussenrändern hin ab, wie das in Fig. 6 dargestellt ist.

Der Kollimator 8 ist gegenüber dem Substrat 3 um eine zentrale Achse 11 drehbar, wobei es gewöhnlich einfacher ist, das Substrat 3 drehbar zu lagern, während der Kollimator 8 fest montiert ist. Die Platten 9 sind so angeordnet, dass jede der Platten 9 mit Ausnahme einer Randplatte durch eine Drehung um 180°, durch die der Kollimator 8 aus einer ersten in eine zweite Position umgestellt wird, an eine Stelle gebracht wird, die etwa in der Mitte zwischen zwei Stellen liegt, an denen vor der Drehung einander benachbarte Platten 9 angeordnet waren und die in der ersten Position des Kollimators 8 von den Platten 9 eingenommenen Lagen in der zweiten Position frei werden. Exakt lässt sich dies nur realisieren, wenn benachbarte Platten 9, wie in Fig. 5 dargestellt, gleichen Abstand haben, doch kann das Ziel auch bei wie bevorzugt nach aussen langsam zunehmendem Abstand der Platten ausreichend genau erreicht werden.

Zur Herstellung einer gerichteten Schicht mit konstanter, der y-Richtung entsprechender ausgezeichneter Richtung auf der Substratfläche 4 wird wiederum in an sich bekannter Weise Kathodenzerstäubung eingesetzt, wobei Targetmaterial in dieseme Fall vor allem längs einer herzförmigen Kurve auf der Targetfläche 6 abgetragen wird. Durch die beschriebenen Weisen, die Platten 9 auszubilden, können Unterschiede in der Dicke der gerichteten Schicht, wie sie sich sonst aus den Asymmetrien der Anordnung ergeben würden, weitgehend vermieden werden, indem geringere lokale Partikeldichte durch Erweiterung des bevorzugten Winkelbereichs kompensiert wird. Umstellung des Kollimators 8 wie ebenfalls oben beschrieben, etwa nach Verstreichen der Hälfte der Beschichtungszeit, dient dem gleichen Zweck, indem dadurch Schattenwirkungen der Platten 9 vergleichmässigt werden.

Das erfindungsgemässe Verfahren kann jedoch in einem breiteren Rahmen angewendet werden als aus den obigen Anwendungsbeispielen hervorgeht. So können auch gekrümmte Substratflächen beschichtet werden und die ausgezeichnete Richtung kann eine - vorzugsweise stetige - Funktion des Ortes sein, also vom Zielpunkt abhängen. Entscheidend ist in jedem Fall, dass der Einfall von Partikeln auf die Substratfläche so gesteuert wird, dass im zeitlichen Mittel in Summe jene Einfallsrichtungen dominieren, deren Projektion auf die Tangentialfläche der Substratfläche - welche im Fall einer ebenen Substratfläche mit dieser zusammenfällt - am jeweiligen Zielpunkt mit der ausgezeichneten Richtung übereinstimmt. Die ausgezeichnete Richtung ist dabei vorzeichenlos definiert, es kommt also nicht darauf an, ob der Einfall von der einen oder der anderen Seite erfolgt.

Wenn die Dichte der Partikeleinfallsrate an einem Zielpunkt mit $\rho(\theta,\varphi,t)$ bezeichnet wird, wobei $\theta$ den Winkel der Einfallsrichtung zur Normalen auf die Substratfläche 4 bezeichnet und $\varphi$ den Winkel zwischen der Projektion der Einfallsrichtung auf die Tangentialebene und einer festen Richtung in derselben, so ist die gesamte, über die Beschichtungszeit T integrierte Einfallsdichte als Funktion der Richtung

$$(1) \quad r(\theta,\varphi) = \int_0^T \rho(\theta,\varphi,t)\, dt, \quad 0 \le \theta < \pi/2, \quad 0 \le \varphi < 2\pi$$

Diese Funktion ist in Fig. 7a,b in zwei zur Tangentialebene der Substratfläche 4 normalen Schnitten dargestellt, wobei die y-Richtung die ausgezeichnete Richtung ist und die x-Richtung die dazu normale. Was die ausgezeichnete Richtung in der Tangentialebene schliesslich bestimmt, ist jedoch eine kumulierte Einfallsdichte, d.h. eine gewichtete Summe über den die Steilheit des Einfalls widerspiegelnden Winkel $\theta$, also

$$(2) \quad R(\varphi) = \int_0^{\pi/2} r(\theta,\varphi) w(\theta)\, d\theta, \quad 0 \le \varphi < 2\pi$$

$w(\theta)$ ist eine Gewichtsfunktion, welche z.B. zu $\sin\theta$, d.h. der relativen Länge der Normalprojektion auf die Tangentialebene, proportional sein kann. $R(\varphi)$ ist in Fig. 8 dargestellt. Die Funktion hat dort, wo $\varphi$ der ausgezeichneten Richtung entspricht, Maxima, da der Partikeleinfall gezielt so gesteuert wurde, dass die Projektion der Einfallsrichtung überwiegend auf einen die ausgezeichnete Richtung umgebenden Winkelbereich von z.B. $\pm\pi/4$ konzentriert oder beschränkt war. Wegen der Definition der ausgezeichneten Richtung als vorzeichenloser Grösse genügt es im Grunde, wenn $R_s(\varphi) = R(\varphi) + R(\varphi+\pi)$, $0 \le \varphi < \pi$ dort ein Maximum hat, doch ist R in der Regel mindestens annähernd spiegelsymmetrisch.

Für die Steuerung des Partikeleinfalls auf die Substratfläche 4 werden zwei Vorgehensweisen bevorzugt, nämlich der Einsatz mechanischer Abschirmmittel wie des Kollimators 8 oder eine Einstellung oder Steuerung der relativen Lage des Substrats und des Targets. So kann etwa das Substrat eine Bewegung relativ zum Target oder den Targets ausführen derart, dass bestimmte Einfallsrichtungen, deren Projektion auf die Tangentialfläche nahe bei der ausgezeichneten Richtung liegen, bevorzugt auftreten. Die Bewegung kann dabei auch ungleichmässig und/oder intermittierend sein und es kann zusätzlich auch die Leistung der Vorrichtung, d.h. die Dichte des vom Target ausgehenden Teilchenstroms mit der Stellung des Substrats zum Target gezielt verändert werden, etwa so, dass sie bei überwiegend flachem Partikeleinfall parallel zur ausgezeichneten Richtung besonders hoch ist. Beide Vorgehensweisen können, wie im ersten Ausführungsbeispiel gemäss Fig. 1-3 gezeigt, auch in Kombination angewandt werden, etwa indem dort die Rotation des Korbes 1 verlangsamt oder angehalten wird, wenn sich die Substrate 3 etwa in der Mitte zwischen zwei benachbarten Targets 5 befinden. Zusätzlich kann dann auch die Leistung erhöht werden.

Die Abschirmmittel sollten dann so ausgebildet und angeordnet sein, dass die Bahnen der Partikel, die im wesentlichen geraden, einen Punkt der Targetfläche mit dem Zielpunkt auf der Substratfläche verbindenden Linien folgen, mit dem Abschirmmittel kollidieren, die Partikel also abgefangen werden, wenn sie andernfalls im Zielpunkt aus einer Richtung einträfen, deren Projektion auf die Tangentialfläche ausserhalb des bevorzugten Winkelbereichs liegt. Mindestens sollte dies im Mittel über Beschichtungszeit und gewichteten Mittel über die Steilheit des Einfalls, d.h. den Winkel $\theta$ überwiegend der Fall sein. Dabei ist es u.U. nötig, auch zu berücksichtigen, dass die Targetfläche unterschiedlich aktive Bereiche aufweist, die Partikel also überwiegend von einem verhältnismässig kleinen Teil derselben stammen, etwa im ersten Ausführungsbeispiel aus der Umgebung der Kurve 7.

Zusätzlich kann, wie oben erwähnt, auch ein Magnetfeld im Bereich des Substrats angelegt werden, doch ist dies in den meisten Fällen nicht erforderlich.

**Bezugszeichenliste**

1  Korb

2  Achse

3   Substrat

4   Substratfläche

5   Target

6   Targetfläche

7   Kurve

8   Kollimator

9   Platte

10  Vakuumkammer

11  Achse

**Patentansprüche**

1.  Vorrichtung zur Herstellung einer gerichteten Schicht auf einer ebenen Substratfläche (4) eines Substrats (3) mit einer jeweils in der Substratfläche (4) liegenden ausgezeichneten Richtung mittels Kathodenzerstäubung, mit einer Vakuumkammer (10), in welcher mindestens ein Target (5) angeordnet ist sowie mindestens eine Halterung, die zur Befestigung eines Substrats (3) derart, dass eine Substratfläche (4) einer Targetfläche (6) des mindestens einen Targets (5) zugewandt ist, geeignet ist sowie mindestens ein zwischen der Targetfläche (6) und der Halterung angeordneter Kollimator (8) mit mehreren ebenen, zueinander parallelen Platten (9), **dadurch gekennzeichnet, dass** die Platten normal zur Substratfläche (4) ausgerichtet sind und die mittlere Länge der Platten (9) von der Mitte des Kollimators (8) gegen äussere Ränder hin abnimmt.

2.  Vorrichtung nach Anspruch 1, **dadurch gekennzeichnet, dass** mindestens ein Teil der Platten (9) eine parallel zur Substratfläche (4) sich ändernde Dicke aufweist.

3.  Vorrichtung nach Anspruch 2, **dadurch gekennzeichnet, dass** jeweils die Dicke von einer Mitte der Platte (9) gegen äussere Ränder hin abnimmt.

4.  Vorrichtung nach einem der Ansprüche 1 bis 3, **dadurch gekennzeichnet, dass** die Lage des Kollimators (8) gegenüber der Halterung zwischen zwei Positionen umstellbar ist, derart, dass in der einen Position jede Platte (9) eine Stelle einnimmt, die in der anderen Position frei ist.

5.  Vorrichtung nach Anspruch 4, **dadurch gekennzeichnet, dass** in der einen Position des Kollimators (8) jede Platte (9), mit der möglichen Ausnahme von Randplatten, eine Stelle einnimmt, die etwa in der Mitte zwischen zwei Stellen liegt, die in der anderen Position jeweils von einer Platte (9) eingenommenen wird.

6.  Vorrichtung nach Anspruch 4 oder 5, **dadurch gekennzeichnet, dass** der Kollimator (8) durch eine halbe Drehung gegenüber der Substratfläche (4) um eine gegen dieselbe gerichtete Achse von der einen in die andere Position überführbar ist.

7.  Vorrichtung nach einem der Ansprüche 1 bis 6, **dadurch gekennzeichnet, dass** der Abstand zwischen benachbarten Platten (9) von einer Mitte des Kollimators (8) gegen äussere Ränder hin zunimmt.

8.  Vorrichtung nach einem der Ansprüche 1 bis 7, **dadurch gekennzeichnet, dass** die Halterung gegenüber der Targetfläche (6) parallel zu den Platten (9) bewegbar ist.

9.  Verwendung einer Vorrichtung nach einem der Ansprüche 1 bis 8 zur Herstellung einer magnetischen Schicht mit einer bevorzugten Magnetisierungsrichtung.

**Claims**

1. A device for producing a directional layer on a flat substrate surface (4) of a substrate (3), with a nominal direction in each case lying in the substrate surface (4), by means of cathode sputtering, the device having a vacuum chamber (10) in which at least one target (5) is arranged, and at least one holder configured for mounting a substrate (3) in such a way that a substrate surface (4) faces a target surface (6) of the at least one target (5), and at least one collimator (8) arranged between the target surface (6) and the holder with a plurality of flat plates (9) parallel to each other, **characterised in that** the plates are oriented orthogonally with respect to the substrate surface (4) and the mean length of the plates (9) diminishes from the center of the collimator (8) towards outer edges.

2. The device according to claim 1, **characterised in that** at least part of the plates (9) has a thickness that changes in parallel to the substrate surface (4).

3. The device according to claim 2, **characterised in that** in each case the thickness diminishes from a center of the plate (9) towards outer edges.

4. The device according to any one of claims 1 to 3, **characterised in that** the location of the collimator (8) with respect to the holder can be changed between two positions in such a way that in one position each plate (9) assumes a place that is vacant in the other position.

5. The device according to claim 4, **characterised in that** in one position of the collimator (8) each plate (9), with the possible exception of the edge plates, assumes a place that is approximately situated in the middle between two places that are respectively occupied by one of the plates (9) in the other position.

6. The device according to claim 4 or 5, **characterised in that** the collimator (8) can be transferred from one position into the other by a half turn with respect to the substrate surface (4) about an axis directed towards the same.

7. The device according to any one of claims 1 to 6, **characterised in that** the distance between adjacent plates (9) increases from a center of the collimator (8) towards outer edges.

8. The device according to any one of claims 1 to 7, **characterised in that** the holder is movable relative to the target surface (6) in parallel to the plates (9).

9. A use of a device according to any one of claims 1 to 8, for producing a magnetic layer with a preferred direction of magnetisation.


**Revendications**

1. Dispositif de fabrication d'une couche orientée sur une surface de substrat plane (4) d'un substrat (3) avec une direction marquée située à chaque fois dans la surface de substrat (4) au moyen de pulvérisation cathodique, avec une chambre sous vide (10) dans laquelle au moins une cible (5) est disposée ainsi qu'au moins une fixation qui convient à la fixation d'un substrat (3) de telle sorte qu'une surface de substrat (4) est tournée vers une surface de cible (6) de l'au moins une cible (5), ainsi qu'au moins un collimateur (8) disposé entre la surface de cible (6) et la fixation avec plusieurs plaques planes (9) parallèles les unes aux autres, **caractérisé en ce que** les plaques sont orientées perpendiculairement à la surface de substrat (4) et la longueur moyenne des plaques (9) diminue du milieu du collimateur (8) vers des bords extérieurs.

2. Dispositif selon la revendication 1, **caractérisé en ce qu'**au moins une partie des plaques (9) présente une épaisseur variant parallèlement à la surface de substrat (4).

3. Dispositif selon la revendication 2, **caractérisé en ce que** l'épaisseur diminue à chaque fois d'un milieu de la plaque (9) vers des bords extérieurs.

4. Dispositif selon l'une quelconque des revendications 1 à 3, **caractérisé en ce que** la situation du collimateur (8) peut être déplacée entre deux positions par rapport à la fixation de telle sorte que chaque plaque (9) adopte un emplacement dans l'une des positions qui est libre dans l'autre position.

**5.** Dispositif selon la revendication 4, **caractérisé en ce que** chaque plaque (9) adopte un emplacement dans l'une des positions du collimateur (8), avec l'éventuelle exception de plaques de bord, qui se situe approximativement au milieu entre deux emplacements qui sont adopté dans l'autre position à chaque fois par une plaque (9).

**6.** Dispositif selon la revendication 4 ou 5, **caractérisé en ce que** le collimateur (8) peut être transféré par une demie rotation par rapport à la surface de substrat (4) autour d'un axe orienté à l'encontre de celle-ci de l'une des positions dans l'autre position.

**7.** Dispositif selon l'une quelconque des revendications 1 à 6, **caractérisé en ce que** l'écart entre des plaques voisines (9) augmente d'un milieu du collimateur (8) vers des bords extérieurs.

**8.** Dispositif selon l'une quelconque des revendications 1 à 7, **caractérisé en ce que** la fixation peut être déplacée par rapport à la surface de cible (6) parallèlement aux plaques (9).

**9.** Utilisation d'un dispositif selon l'une quelconque des revendications 1 à 8 pour la fabrication d'une couche magnétique avec une direction de magnétisation préférée.

Fig. 1

Fig. 2

Fig. 3

Fig. 4

Fig. 5

Fig. 6

Fig. 7a

Fig. 7b

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6790482 B2
- US 20030146084 A1
- WO 9608817 A1
- US 6482301 B1
- US 5584973 A
- US 5650052 A
- US 2003062260 A1
- US 2003019745 A1